# EUROPEAN PATENT APPLICATION

(11) **EP 2 367 058 A1**
(43) Date of publication of application: **21.09.2011**
(21) Application number: 10290142.8
(22) Date of filing: 17.03.2010
(51) Int. Cl.: G03F 7/24, G03F 7/20, G01D 5/00

(54) **Fabrication method of cylindrical gratings**

(71) Applicant: Université Jean-Monnet, 42000 Saint Etienne Cedex 2 (FR)
(72) Inventor: Parriaux Olivier, 42000 Saint-Etienne (FR); Lyndin Nikolay, Moscou 113189 (RU); Tonchev Svetlen, 15282 Sofia (BG)
(74) Representative: Surmely, Gérard

(57) **Abstract**

The present invention solves the stitching problem and the problem of a predetermine integer number of grating lines per closed circle of a cylindrical grating by resorting to a novel phase mask method which proposes to geometrically transform and to optically transfer a standard planar radial grating pattern (1) into a cylindrical photoresist pattern (9) at the circularly cylindrical wall (7) of a given element (3). The planar radial grating pattern can be easily written with an integer number of lines having strictly constant period without any stitching problem by means of the available tools of planar technologies such as a laser or electron beam generator and reactive ion etching. The photolithographic transfer is made by illumination means (19) which permit the needed geometrical transformation from a planar radial grating to a circularly cylindrical grating, in particular by providing a cylindrical wave having a non-zero axial component and the same central axis (A) as said circularly cylindrical wall or a spherical wave (B) with its center on this central axis.

## Description

### Field of the invention

The present invention concerns a fabrication method of cylindrical gratings for possible application in the domain of high resolution optical measurement of rotation, in the domain of spectroscopy and more generally for the domain of diffractive optics involving cylindrical waves.

### Background of the invention

The high resolution optical measurement of rotation is usually made by means of a radial diffraction grating of micron scale or submicron scale period in the form of a ring defined at the surface of a rotating encoder disk as shown in document US 5,498,870. The two diffraction orders diffracted in transmission or in reflection, directed along and opposite to the tangential displacement direction at the impact point of an incident beam experience an optical phase shift of opposite sign proportional to the local linear displacement and are recombined by means of a second, non-rotating, radial grating which directs both phase shifted diffracted beams in a common direction where they interfere. For the interference contrast to be close to one (1), the relative positioning of the two radial gratings must be precise and stable during relative rotation. The smaller the encoder disk, the more critical the relative positioning conditions between the disk grating and the second grating. A small grating ring diameter implies in particular that the length of the radial grating lines must be short if an acceptable contrast is to be preserved upon relative rotation in the presence of eccentricity due to imperfect alignment between the rotation axis and the center of the encoder disk, and due to mechanical shocks; this in turn implies that the fraction of optical power impinging onto the encoder disk and experiencing diffraction and interference decreases with a decrease of the encoder disk diameter in order to preserve an acceptable interference contrast as described in document Yves Jourlin, Olivier Parriaux, and Jörg Fuchs, "Miniature holistic displacement sensor by immersion diffractive interferometry," Opt. Express 17, 9080-9088 (2009). As a result, a rotation encoder of small diameter of the state of the art either has its interference contrast spoiled by the least eccentricity or uses only a very small fraction of the available power of the light source.

It is therefore desirable to adopt a diffractive interferometric scheme which is little sensitive to eccentricity and in which most of the power delivered by the light source participates in the interference between the orders carrying the information on the rotation. This can be achieved by using two cylindrical gratings where the grating lines are parallel to the rotation axis and are defined on the circularly cylindrical wall of a circular encoder disk or rod.

It is to be noted that cylindrical gratings would not only be useful for stand alone rotation sensors. They could be used in direct drive systems where there is no room to place a standalone rotation encoder; therefore the encoding grating must be defined at the wall of the shaft. Beyond rotation measurement applications, there are other applications in metrology, in spectroscopy, and more generally in diffractive optics involving cylindrical waves, where fine pitch cylindrical gratings are needed.

The main difficulty in defining a possibly submicron short period corrugation grating at the wall of a circular plate or circular rod is to print an integer number of parallel grating lines and grooves in a closed circle without stitching error, and to print this cylindrical grating with strictly constant period, i.e., without wobble in the spatial frequency. The solution consisting in wrapping and pasting a thin plane grating of rectilinear lines around a cylindrical surface as disclosed in document JP 7146405 does not permit a precise stitching between the last and the first grating lines. Usually, the encoder disk is placed on a high accuracy lathe; a tool machines or prints the grating lines parallel to the rotation axis every increment of the angular abscissa as disclosed in document WO 99/20427 "Method for manufacturing of optical torque transducer". The regularity of the period and the accuracy of the stitching is however limited which makes such approach improper for fine pitch cylindrical gratings. It is therefore desirable to have a grating printing method which permits to solve the above mentioned problems. The present invention thus proposes to print a cylindrical corrugation of wavelength scale period in a photoresist layer spread evenly onto the cylinder surface with an exactly predetermined integer number of periods.

It is to be noted that the LIGA process permits transferring the pattern of a thick planar metal mask into a polymer substrate by means of an almost diffraction-less X-ray beam. However, if the pattern of the X-ray mask is the corrugated edge of a metal layer defining a crenellation of micrometer or submicrometer period and submicrometer depth, the imperfect collimation of the X-ray beam results in a smoothing out of the corrugation on the wall at less than 1 millimeter under the metal mask as illustrated in document by C.J. Moran-Iglesias, A. Last, J. Mohr, "Improved grating spectrometer", Prod. SPIE, Vol. 5962, pp. 596225.1-596225.9. The LIGA process is thus not efficient for fabricating uniform cylindrical corrugations having long lines. This is a great limitation.

### Summary of the invention

The invention concerns a fabrication method of a cylindrical grating at a circularly cylindrical surface of an element, characterised by the following steps :
- providing a plan radial grating defining an annular phase mask with radial lines;
- coating said circularly cylindrical surface with a photoresist layer;
- arranging said circularly cylindrical surface relative to said annular phase mask so that the central axis of this circularly cylindrical surface comprises the centre of the annular phase mask, so that said central axis is substantially perpendicular to the plane defined by said annular phase mask, and so that the medium or media between this annular phase mask and the photoresist layer on the circularly cylindrical surface is transparent at least for a given wavelength;

- exposing said annular phase mask with a light wave substantially at said given wavelength and substantially under purely conical incidence, said plan radial grating having a period selected so as to have the +1^{st} and -1^{st} diffraction orders propagating in said medium or media between the annular phase mask and the photoresist layer, the incidence angle of said light wave on said annular phase mask being selected so that said +1^{st} and -1^{st} diffraction orders impinge on said photoresist layer in a cylindrical zone where the cylindrical grating shall be located;
- developing the photoresist layer resulting in a circularly cylindrical photoresist corrugation grating having lines parallel to said central axis.

Then, it is namely possible to form a final cylindrical grating by physically transferring or embossing or injection moulding or extruding said circularly cylindrical photoresist corrugation grating.

The present invention thus solves the stitching problem and the problem of a predetermined integer number of grating lines per closed circle by resorting to a novel phase mask method which allows a standard planar radial grating pattern to be geometrically transformed and optically transferred into a cylindrical photoresist pattern at the circularly cylindrical wall of an element. The planar radial grating pattern can be easily written with an integer number of lines having strictly constant period without any stitching problem by means of the available tools of planar technologies such as a laser or electron beam generator and reactive ion etching. The photolithographic transfer is made by illumination means which permit the needed geometrical transformation from a planar radial grating to a circularly cylindrical grating.

In a first variant, the annular phase mask is a transmission phase mask directly arranged on a top face of the element defining the circularly cylindrical surface, this element being transparent for the given wavelength and the light wave is propagating in a diverging manner relative to the central axis of this circularly cylindrical surface when impinging on the annular phase mask.

In a second variant, the annular phase mask is a transmission phase mask arranged on, under or into a stand alone disk or wafer arranged over or on a top face of the element, this disk or wafer being transparent for the given wavelength.

In a further variant, the annular phase mask has an external radius smaller than the radius of the circularly cylindrical surface of the element which is transparent for the given wavelength, the light wave propagating in a diverging manner relative to the central axis of the circularly cylindrical surface when impinging on the annular phase mask.

In another variant, the annular phase mask has an internal radius greater than the radius of the circularly cylindrical surface of the element, the light wave propagating in a converging manner relative to the central axis of this circularly cylindrical surface when impinging on the annular phase mask.

In a particular embodiment, the annular phase mask is arranged on a support having a hole in which the element having the circularly cylindrical surface is arranged. In a variant of the particular embodiment, the light wave is propagating in a converging manner relative to the central axis of the circularly cylindrical surface when impinging on the annular phase mask. In a further variant of this particular embodiment, an annular conical mirror surrounds the annular phase mask and reflects the light wave in the direction of this annular phase mask.

It is to be noted that, depending on the considered variant of the invention, the annular phase mask is either a reflective phase mask or a transmission phase mask, i.e. the phase mask is used either in reflection or in transmission.

It is also to be noted that, depending on the considered variant of the invention, the circularly cylindrical surface is ether convex or concave and respectively defines an external wall or an internal wall of the element.

According to a particular feature of the invention, a layer is deposited on the area outside the annular phase mask, this layer being absorptive or reflective when this annular phase mask is used in transmission, respectively absorptive or transmissive when this annular phase mask is used in reflection.

The present invention also allows to define several gratings of different period next to each other on the same cylinder, and it also allows the printing of two or three identical cylindrical gratings on the same wall having a prescribed angular shift between each other so as to enable the simultaneous detection of nondegenerate rotation signals (for instance sine and cosine functions) in a rotation encoder application. It also allows the printing of a cylindrical grating made of different sections, each section having a different grating period or having the same period but a definite phase shift between them.

### Brief description of the drawings

Figure 1 is the top view of a radial phase mask arranged at the upper face of a circularly cylinder for putting into practice the fabrication method according to a first embodiment of the present invention.
Figure 2 is a transverse view of the device shown in Figure 1 through the central axis of the cylinder.
Figure 3 is a perspective view of the device of Figure 1 together with illumination means according to a first embodiment.
Figure 4 is a transverse view similar to that of Figure 2 with the first embodiment of the illumination means.
Figure 5 is a transverse view similar to that of Figure 2 with a second embodiment of the illumination means.
Figure 6 is a transverse view similar to that of Figure 2 with a third embodiment of the illumination means.
Figure 7 is the transverse view of a transfer radial phase mask formed in or on a stand alone disk which is arranged on the top face of a circularly cylinder for putting into practice the fabrication method according to a variant of the first embodiment of the present invention.
Figure 8 is the top view of a transfer radial phase mask arranged at the upper face of a cylinder or disk for putting into practice the fabrication method according to a further variant of the first embodiment of the present invention.
Figure 9 is a transverse view in a plane containing the central axis of a cylinder in a configuration for putting into practice the fabrication method according to a second embodiment of the present invention.

### Detailed description

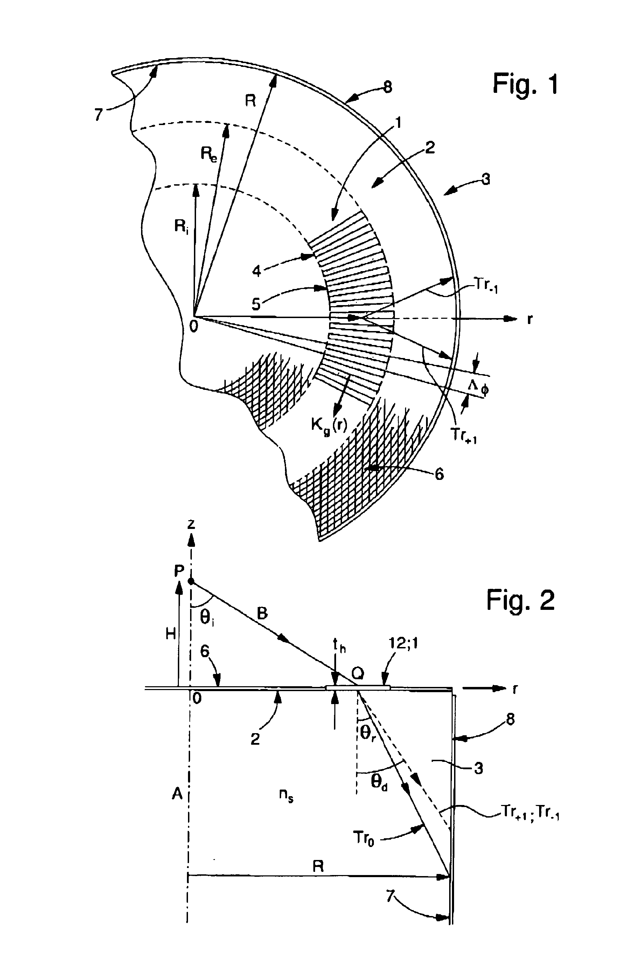

A first embodiment of the invention will now be described with reference to Figures 1 to 4. A binary radial grating 1 of depth to defined at the upper face 2 of a circularly cylindrical element 3 of radius R, of transparent material of refractive index nₛ, comprising lines 4 of width wₗ(r) and grooves 5 of width w_{g}(r) where r is the radial coordinate with origin O. The radial dependence of wₗ(r) and w_{c}(r) is linear in the radial coordinate r, so is the period Λ_{g}(r) = wₗ(r) + w_{g}(r) of the grating phase mask 1. The dimensionless angular period Λ_{φ} is Λ_{g}(r)/r. Grating 1 covers an area in the form of a ring of inner radius R and external radius R. There can be several concentric rings of different corrugation period and phase and of different length of lines (and grooves). The center O of the radial grating 1 is the point where all grating lines 4 and grooves 5 intersect. O is also preferably the center of the grating ring, but not necessarily. O is on the axis A of the cylindrical element 3. The upper face 2 of the element 3 except the ring of grating 1 is coated by an absorptive or reflective layer 6 such as chromium to prevent non-diffracted transmitted light to interfere with the wave diffracted by grating 1 and to reduce scattering in the cylindrical element 3.

Figure 2 is a cross-sectional view of the exposure configuration in a plane normal to the element surface 2 and containing the axis A of the cylindrical element 3, called an incidence plane. All phase mask grating lines 4 and grooves 5 are oriented along a different incidence plane and all exposure light rays are contained in incidence planes. An exposure ray B of wavelength λ originates from, or crosses the axis A at point P at distance H from O. Ray B makes an angle θ, with the axis A and impinges onto the grating 1 at point Q of radial coordinate r. At any point Q the local K-vector of the phase mask grating 1 is normal to the incidence plane containing Q. Such incidence condition where the incidence plane of any oblique incident ray is normal to the local K-vector of the grating will be called in the present document purely conical incidence in contrast with collinear incidence where the K-vector of the grating is in the incidence plane, and with conical incidence where the grating K-vector has a non-zero component in the incidence plane and a non-zero component normal to the incidence plane. A purely conical incidence relative to a plan annular radial grating is namely obtained by a cylindrical wave propagating with a non-zero axial component of its k-vector along the normal axis to the plan annular radial grating passing through its center or by a spherical wave centered on this normal axis. The illumination conditions will be described later.

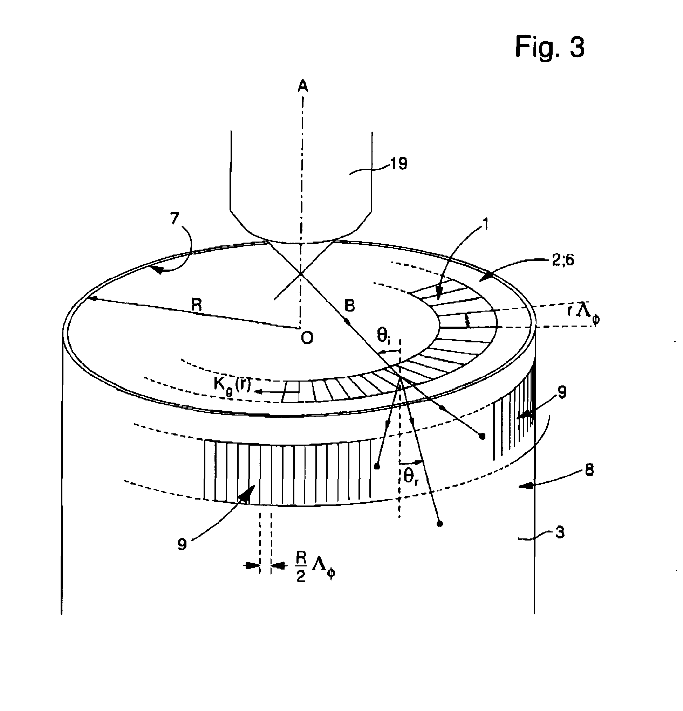

At point Q the 0^{th} transmitted order Tr₀ of grating 1 is refracted into element 3 under an angle θᵣ = arcsin (sinθᵢ/nₛ) in a incidence plane containing Q. At point Q ray B is also diffracted into the element 3 by the phase mask grating 1 of local radial K-vector K_{g}(r) = 2π/Λ_{g}(r). K₀(r) is directed along the tangent of a circle of radius r centered at O, i.e. along the azimuthal unit vector of a cylindrical coordinate system r, φ, z; z being along the rotation axis A. At point Q the +1^{st} and -1^{st} diffraction orders Tr₋₁ and Tr₋₁ diffracted in transmission into element 3 have their K-vector radial component k₀Sinθᵢ = k₀nₛsinθᵣ, azimuthal component +/-K_{g}(r), and axial component k₀(n_{g}²/cos²θr - K_{g}²/k₀²)^{½} where k₀ = 2πt/λ. In element 3 the diffraction orders of order m propagate under an angle ηₘ with the surface 2 of the cylindrical element given by cosηₘ = ((mK_{q})²+k₀²sin²θₜ)^{1/2}/(nₙkₙ). In projection in the incidence plane, the angle θ_{d} defined by the +/-1 diffraction orders is greater than the refraction angle θᵣ. The relationship between θ_{d} and θᵣ is given by the formula tgθ_{d} = n,sinθᵣ /(n₉²cos²θᵣ - K₀²/k₀²)^{1/2}. Thus tgθ_{d} is greater than tgθᵣ. In the element 3 the two +1^{st} and -1^{st} diffraction orders give rise to an interferogram of optical power distribution proportional to (1 + q cos(2K_{g}(r) r φ)) where q is an interference contrast term comprised between 0 and 1 depending on the diffraction efficiency of the phase mask grating 1 and on the incident polarization. As K_{g}(r) of a radial grating is inversely proportional to r, the angular period Λφᵢ of the interferogram along the azimuthal abscissa φ at any radial abscissa r is constant and equal to Λ_{φ1} = Λ_{φ}/2. This means that the period Λ_{c}(R) of the interferogram projected onto the cylindrical wall 7 coated with a photoresist layer 8 at r = R is Λ_{c}(R) = Λ_{φ}R/2. The exposure of the photoresist layer 8 to the interferogram after development gives rise to a corrugation grating 9 in the photoresist layer of period Λ_{φ}R/2 as represented in perspective in Figure 3. The lines and grooves of the grating transferred onto the cylindrical wall 7 are parallel to the axis A. An essentially sinusoidal corrugation profile results if the photoresist is set at its linear regime by uniform pre-exposure, and a binary corrugation profile results if the photoresist is set below threshold and exposed above saturation. The deposition of a uniform photoresist coating 8 on the cylinder wall is preferably made by dip-coating. The photoresist thickness is adjusted so as to prevent the creation of standing wave field nodes withing the photoresist layer 8; this is the case if high reflection occurs at the air-photoresist interface in case the incidence angle of the +/-1^{st} orders at the cylindrical wall is large. The formation of a standing wave can be suppressed by immersing the cylinder in a liquid of refractive index close to nₛ, as for instance glycerol, which does not perturb the photochemistry of a standard positive photoresist. An index matching liquid will also be used in case of total internal reflection in the cylindrical element with air as the external medium. As an alternative to an external liquid, the photoresist layer 8 can be coated with an absorptive film of non-critical thickness such as an absorptive latex film to suppress the reflection at the photoresist-air interface.

As from the photoresist development step, a number of processes can be used to obtain a cylindrical grating in hard material such as dry or wet etching of the element wall 7, or the electrochemical or electroless growth of a metal shim (nickel for instance) on the resist grating 9, followed in turn by a highly productive injection molding or UV- or hot-embossing process from a nickel shim or casting or extrusion. A grating in hard material can also be obtained by a lift-off process whereby the developed photoresist grating 9 having its grooves preferably in the form of inverse trapezes is first coated by a metallic or dielectric layer, then the photoresist trapezes are chemically removed together with the layer material deposited on them, leaving lines of the deposited material where the resist grooves were.

The circularly cylindrical symmetry of the interferogram is a consequence of all exposure rays being contained in incidence planes normal to the element surface 2 and containing axis A. The exposure radiation is preferably narrow band and has a high spatial coherence such as that of a HeCd laser at 442 nm or 325 nm wavelength or a single transverse mode semiconductor laser at 406 nm wavelength. The circularly cylindrical symmetry of the interferogram does not depend on the angle of incidence θ₁ and on the height H of point P above element surface 3. The incidence of all rays on the radial phase mask grating is purely conical.

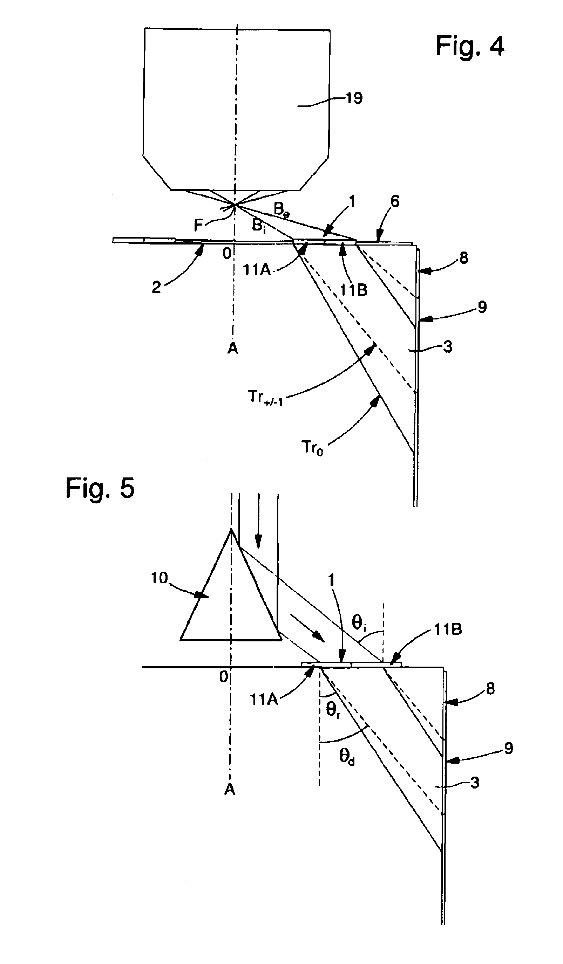

The illumination is provided by means of a high aperture microscope objective 19 centered on the axis A as shown in Figure 4. The microscope objective has a large angular aperture to give rise to rays of large incidence angles on the phase mask grating 1; the oblique beams passing through the focus point F of objective 19 with incidence comprised between ray B₁ and ray Bₑ illuminate two phase shifted annular parts 11A and 11B of the radial grating 1. This phase mask with two phase shifted annular parts is only given here as an example. In the present embodiment, all exposure rays belong to a spherical wave centered at F; only those rays of the spherical wave will be used which are comprised between the angle of ray B and the angle of ray B. An advantage of this embodiment with microscope objective is the possibility to visualize the centering of the phase mask grating 1 and the cylinder element 3, and to expose with the same optical element. In this case, the incident ray is preferably radially polarized. There are several means to obtain a radially polarized beam. A first one is by using an intracavity grating mirror with concentric circular grating lines as described in document WO0109650. A second means is to use a thin undulated metal film with concentric circular lines embedded in a polymer matrix exhibiting resonant transmission according to document US 2007/0147221 A1.

Another illumination configuration is shown in Figure 5. The resist layer 8 is exposed in a single exposure through the phase mask grating 1 by means of a reflective cone 10 defining a conical mirror having A as its central axis and receiving the light beam, e.g. under an incidence parallel to the axis A. The incidence angle 0ᵢ is the same for all rays. All rays belong to a spatially coherent exposure wave which, after reflection on the cone 10, propagates as a cylindrical wave with a non-zero axial component of its k-vector. The polarization distribution of the incident beam is preferably radial to ensure a high contrast interferogram. A radial polarization here means that the electric field of the incident ray is contained in the incidence plane.

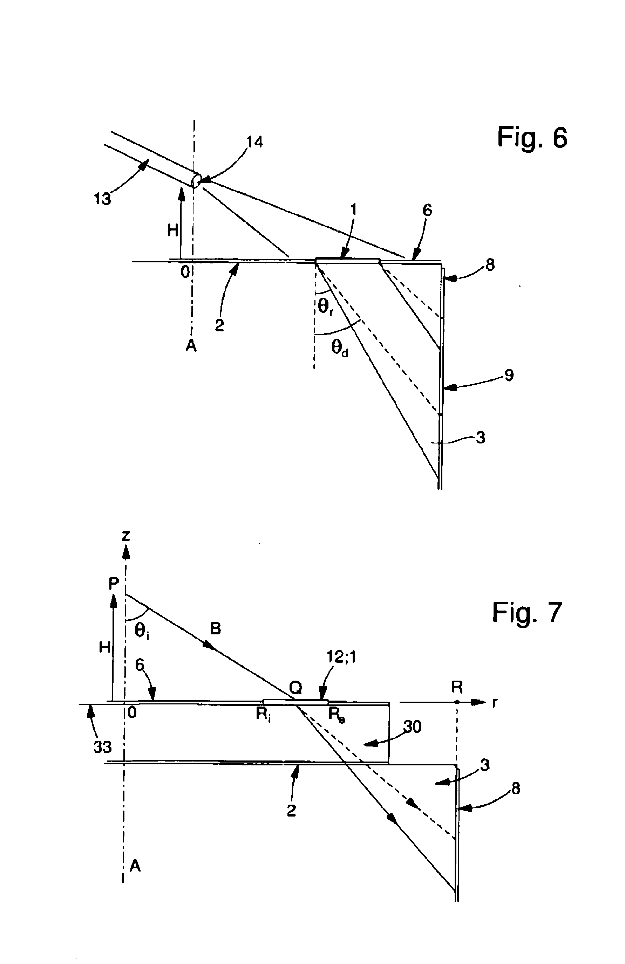

Another interesting exposure configuration is illustrated in Figure 6 where the exposure is made by means of an optical fiber 13 providing a low divergence beam. The end-face 14 of the optical fiber is preferably substantially placed on the axis A. A high accuracy rotation stage of this fiber relative to the annular phase mask with a rotation axis identical to A brings each part of the radial grating 1 under the divergent exposure beam with possibly several turns to smooth the dose distribution across the stitching zone. Delivering the total exposure dose in the form of several turns with small dose permits to limit the dose jumps where the exposure began and where it ended. This configuration presents the advantage that a linear polarization can be used, the electric field of the exposure beam being in the incidence plane. This exposure configuration is particularly advantageous for the writing of a cylindrical grating at the wall of a cylinder of large diameter, for instance as large as 300 mm where the radial phase mask grating 1 also has a large inner and outer diameter, for instance 293 and 298 nm respectively.

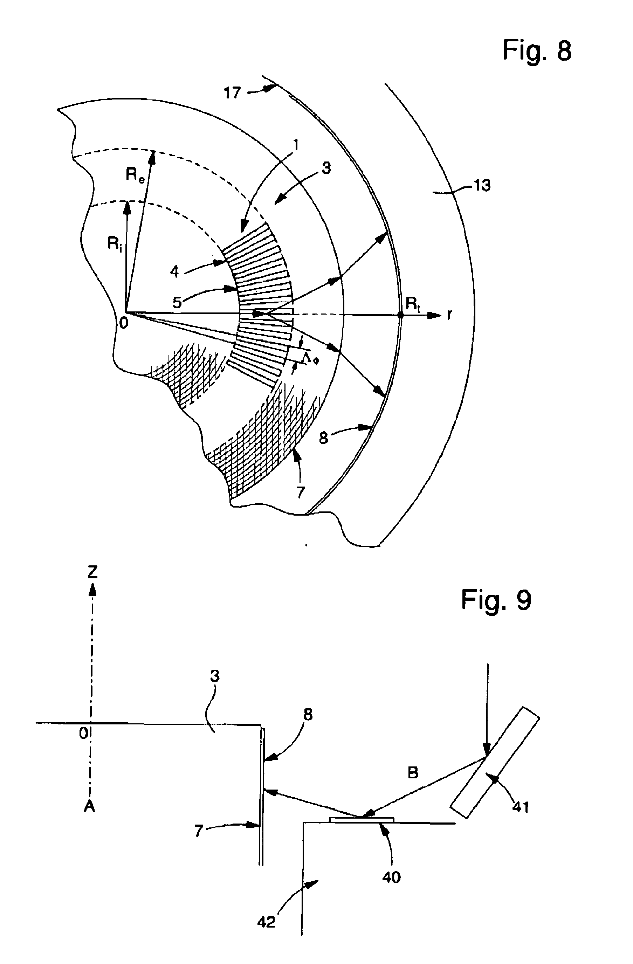

In another embodiment of the invention, the phase mask is illuminated by a converging cylindrical wave instead of a diverging cylindrical wave as represented in Figure 9 and described later.

In all exposure configurations, measures are preferably taken to ensure an even power distribution in the photoresist layer 8 along the z axis by shaping the radial power distribution in the incident beam.

The pattern of the phase mask grating 1 comprises radial lines 4 and grooves 5 of radially dependent widths w₁ and w₀ respectively. It is preferably a binary corrugation with essentially vertical walls. The pattern can be written by means of a laser or electron beam pattern generator in a photo- or electron sensitive resist layer. A subsequent etching process transfers the resist grating pattern in the form of rectangular profile grooves into the element surface 2 at a depth t_{g} or, as shown on figure 2, into and all through a high index layer 12 of refractive index nₕ and appropriate thickness tₕ deposited onto surface 2, tₕ being also the depth of the grooves. At the exposure wavelength λ the minimum period Λₘ of the phase mask grating 1 which can be projected onto the cylindrical wall 7 is Λₘ > λ/(n² - sin²θ₁)^{1/2} so that the +1^{st} and -1^{st} diffraction orders can propagate into the element 3. It is an interesting advantage of purely conical incidence over normal incidence that the period at which higher diffraction orders appear is larger; this permits to extend to larger periods the period domain of single diffraction order. The maximum period Λ_{M} of the phase mask grating 1 which can be projected with fidelity onto the cylinder wall 7 is Λ_{M} < 3λ/(n²-sin²θ)^{1/2} in order to prevent the propagation of the 3^{rd} order diffraction orders in the element 3 whereas the +2^{nd} and - 2^{nd} orders, which usually have relatively small amplitude, are allowed to propagate.

There are however situations under purely conical incidence where the +2^{nd} and -2^{nd} orders do not have negligible amplitude and need be suppressed; in this case, Λ_{M} < 2λ/(n²-sin²θ₁)^{1/2}. If the phase mask grating 1 diffracts higher diffraction orders into the element 3 with non negligible efficiency, the interferogram exposing the cylinder wall 7 exhibits in the azimuthal direction different spatial frequencies superposed to the desired one resulting from the interference of the +1^{st} and -1^{st} orders and, in addition, the interferogram lines parallel to the axis exhibit periodic minima and maxima along z. There are two possibilities to avoid the superposition of spurious spatial frequencies along coordinates φ and z. Spurious modulation of the desired grating lines along z can be suppressed by considering that the higher diffraction orders of order m propagate in the cylinder at a smaller angle ηₘ relative to the element surface 2 than the desired +1^{st} and -1^{st} orders. If the cylinder wall 7 is placed far enough from the phase mask, these do not overlap any more on the cylinder wall. The second possibility to prevent spurious interferograms is to use a phase mask period which does not permit the diffraction of the +/-2^{nd} orders in the element in cases where these second orders would have non-negligible amplitude.

Advantage can be taken from the period magnification which results from the cylindrical symmetry: by setting R large enough with respect to R, and Rₑ, an interferogram period as large as desired can in principle be defined without any spurious over-modulation. The binary groove depth of the phase mask corrugation is chosen so as to cancel or to minimize the transmitted 0^{th} order in order to have q as close to 1 as possible and to give rise to an interferogram of high contrast without over-modulation. The groove depth t_{g} (if the grooves are etched in the element surface 2) or tₕ (if the grooves are etched into and all through a high index layer 12) as well as the line/groove ratio w₁/w₀ giving rise to zero or minimum 0^{th} order transmission into the element 3 can be provided by existing commercial codes such as "Grating Solver". Having an approximate depth for the cancellation of the transmitted zero^{th} order i3 useful; it is obtained by means of the scalar approximation which states that the depth t of a binary grating of 50/50 line/groove ratio under conical incidence of incidence angle θᵢ in air leading to a cancellation of the 0^{th} transmitted order is t = λ/(2(ncosθ - cosθᵢ)) where t = tₒ and θ = θᵣ if the corrugation is made in the element 3 of index n = nₛ and t = tₕ and θ = arcsin(sinθᵢ/nₕ) if the corrugation is made through a high index layer 12 of index n = nₕ. This approximation is very rough in wavelength scale gratings, but it can advantageously be the starting point of an optimization procedure.

As a first example, the depth t₀ ensuring the cancellation of the 0^{th} transmitted order of a fused quartz phase mask grating 1 of refractive index nₛ = 1.46, of average period A_{q}((R₁+Rₑ)/2) = 1 µm for the projection of an interferogram on a cylindrical wall 7 by means of an exposure wave at λ = 442 nm wavelength under θ₁ = 60 degree incidence in air with the electric field polarized in the incidence plane is 348 nm with a line/groove ratio w₁/w_{g} of 410 nm/590 nm. The residual transmitted 0^{th} order power is essentially zero for 40% transmitted power in the +1^{st} and -1^{st} orders. The diffraction efficiency in each second order is close to 10%. As a second example, the phase mask grating 1 made in a Si₃N₄ layer (nₙ = 2) for the same period and identical incidence conditions requires a depth tₕ = 169, a line/groove ratio w₁/w₀ = 410 nm/590 nm and gives rise to a residual power of essentially zero in the 0^{th} transmitted order, 32% in the + and -1^{st} orders and close to 10% in the second orders. In these two examples the ratio of the phase mask period to the exposure wavelength is such that the second transmitted diffraction orders do propagate into the element; whereas the amplitude of the 0^{th} order can be cancelled, the + and -2^{nd} orders can not, and have a diffraction efficiency of about 10%, i.e., the ratio of the power diffraction efficiencies of the 1^{st} and 2^{nd} orders is about 4 which means that the ratio of their field amplitudes is about 2; this will give rise to highly spurious over-modulation in the desired interferogram. The way to suppress the over-modulation is to let the light sheet containing the +1^{st} and -1^{st} order interferogram making the angle η₁ with the element surface to spatially separate from the light sheet containing the +2^{nd} and -2^{nd} order interferogram making the angle η, with the element surface.

A preferred exposure configuration is that which suppresses the 2^{nd} transmitted orders, i.e., which essentially achieves the condition on the average period of the phase mask, Λ_{g}((Rₑ+Rₜ)/2), satisfying Λ_{g}((Rₑ+R)/2) < 2λ/(nₛ²- sin²θᵢ)^{1/2}. A third example refers to a phase mask grating which only diffracts the +1^{st}, 0^{th} and -1^{st} orders into the element 3. The high index layer 12 is made of silicon nitride, the wavelength is also 442 nm, the electric field is also polarized in the incident plane. The incidence angle θᵢ is 45 degrees. The average period is 650 nm. A silicon nitride layer of thickness 213 nm with grooves etched all through, a line/groove ratio of 343 nm/307 nm ensures the cancellation of the 0^{st} transmitted order and about 40% diffraction efficiency in the transmitted +1^{st} and -1^{st} orders.

The radially variable period of the phase mask grating 1 and the line/groove ratio can be produced by electron beam patterning with high precision and can be varied with high flexibility across the whole area of grating 1. In particular, the area of grating 1 can be composed of two or three sub-areas of concentric ring shape of the same angular period Λ_{φ} but predetermined angular shift corresponding to a prescribed fraction of the period Λ_{φ}. This results in two or three grating parts on the cylindrical wall 7 of identical period but predetermined shift. This is an important characteristic of the disclosed grating writing method for the fabrication of rotation encoders where one grating section delivers the sinus and the other section the cosinus of the rotation signal. If a shift of a fraction 1/N of a period at the cylinder wall between two grating segments or rings is desired, N being an integer number larger than 1, the corresponding shift in the phase mask grating 1 is a fraction 1/(2N) of a period.

The radial phase mask grating 1 can also have a variable angular period Λ_{φ}(φ) to give rise for instance to an azimuthally chirped grating on the cylinder wall (i.e. a grating of varying period). A too large chirp rate, a too large distance D between the phasemask and the element edge D = (R - (Rₑ+Rᵢ)/2) would lead to an overlap between diffraction orders and to a deterioration of the contrast of the interferogram on the element wall. An approximate limit for the tolerated chirp rate for the preservation of the contrast is dK₀((Rₑ+Rᵢ/2)/ds * Dtgξ << π where dK_{g}((Rₑ+R)/2)/ds is the derivative of the phase mask grating K-vector K_{g} at the middle of the grating relative to the curvilinear abscissa s along the circle of radius (Rₑ+R₁)/2 and ξ is the 1^{st} order diffraction angle in the plane of the element given by sinξ = λ/(nₛΛ_{g}((Rₑ+R₁/2)).

The radial phase mask grating can comprise a number of concentric sub-areas of different angular period which results on the cylindrical wall 7 in a number of cylindrical gratings of lines parallel to axis A and of different periods. The radial phase mask grating can be decomposed in a number of sections of identical azimuthal period with a phase shift between them in order to project on the cylinder wall 7 an interferogram having phase shifted sections. This is used for instance for having phase shifted grating sections in the same grating track on the cylinder.

The interferogram does not have to be printed at the surface of the very cylinder at the surface of which the phase mask is microstructured. As illustrated in Figure 7, higher productivity and more flexibility is gained by defining the phase mask 1 on a thin stand alone disk or wafer 30. The cylinder 3 at the surface of which the interferogram is to be projected is placed concentrically with the stand alone phase mask support 30 which is arranged on or over the top face 2 of the cylinder 3, preferably with an index matching liquid film 33 in-between. The phase mask 1 can also be placed at the bottom surface of wafer 30 at the side of the index matching fluid. In this case the grating lines 4 of the phase mask grating 1 are made of a high refractive index material such as Si₃N₄ or Ta₂O₅ or TiO₂. The phase mask can also be an index modulation within the disk 30 obtained for instance by ion implantation or by embedding a high index corrugation within a sandwich of two plates by wafer direct bonding.

The examples of the figures 1 to 7 concern a fabrication method for a cylindrical grating at the convex wall 7 of a circular plate or rod by means of a radial phase mask grating illuminated by a diverging beam. The same method can used to project the interferogram onto the concave surface 17 of an element 13 having a circularly cylindrical surface 17 of inner radius Rₜ surrounding a support 3 on which the annular phase mask is arranged concentrically to the circularly cylindrical surface 17, as illustrated in Figure 8. The support 3 is placed in a hole of the element 13. The photoresist layer 8 is spread at the inner wall 17 of the element 13. The period Λᵣ of the grating printed in the photoresist layer 18 at the surface 17 of the element 13 is Aₜ = Λ_{φ}Rₜ/2. An index matching liquid is preferably used between the support 3 and the circularly cylindrical surface 17 of the element 13. It is to be noted that the phase mask 1 can be used in reflection or in transmission according to two different variants.

An alternative to an exposure method applied to a concave wall is to make a negative replica of a cylindrical grating made on a convex cylinder 3 as described initially. This replica can be made in the form of a nickel shim grown on the convex photoresist grating followed by the dissolution of the resist grating and withdrawal or dissolution of the cylindrical element. The Ni-shim becomes the wanted concave grating. Higher productivity can be obtained by replicating this concave grating in the form of a nickel convex cylindrical 1 grating, itself being replicated, possibly several times, to give rise to a number of replicated concave gratings.

Another alternative for writing a grating at the inner wall of a tube is to use as radial grating phase mask 1 a reflection radial grating where the lines 4 and grooves 5 of the phase mask are metal coated. The interferogram is produced by the + and -1^{st} reflected diffraction orders. The needed groove depth t_{g} and the line/groove ratio essentially canceling the 0^{th} reflected order can be calculated by means of an exact optimization code available commercially. However, an approximate depth for t_{g} with equal groove width and line width is t_{g} = - λ/(4cosθᵢ). Layer 6 is here an absorptive or highly transmissive layer.

A specific advantage of the disclosed phase mask grating writing method is that it can write a grating of period notably larger than the wavelength if R or Rᵣ is large without suffering from the presence of high diffraction orders since the phase mask grating generating the circularly cylindrical interferogram can be made to substantially diffract the +/-1^{st} orders only.

In particular in cases where the grating has to be made on the wall of a cylinder or on the external wall of a tube of small diameter or when the cylinder is not transparent to the illumination beam, a annular radial grating phase mask 40 is arranged, according to a second embodiment of the present invention, outside the tube or cylinder 3 on a support 42. This annular radial grating phase mask 40 is illuminated as shown in Figure 9 by a spatially coherent converging beam produced by the inner wall of an annular conical mirror 41 reflecting a normally incident beam. In this variant, the phase mask 40 is a reflective phase mask. It is to be noted that, in a variant, the initial incident beam can be diverging. The slope of the conical mirror is thus selected so that the reflected beam substantially impinges on the phase mask 40. Thus it is also possible in a variant to use the illumination means (optical fiber) shown in Figure 6 in the second embodiment of Figure 9. In a further variant, it is also possible to use an optical fiber, but oriented so as to provide an illumination beam in the direction of the central axis A. The +/-1^{st} diffraction orders diffracted in reflection by the phase mask 40 impinge on a photoresist layer 8 covering the wall 7 of the cylinder 3. The writing of the cylindrical grating occurs in the same way as described for the first embodiment. The annular conical mirror 41 and the support 42 can be parts of a single monolithic element. In a further variant, the phase mask rests at the surface of a transparent support having a hole with a polished wall and the phase mask 40 is a transmission phase mask. In the hole is cylinder 3 whose cylindrical wall 7 is coated by a photoresist layer 8 and whose axis A coincides with the center of the annular phase mask 40. In another variant, the transparent support has no hole and is placed on the cylinder 3. The diffracted beams in transmission pass through the transparent support and impinge on the wall of cylinder 3. An anti-reflective layer can be deposited on the lower face of the support. This last case essentially corresponds to the variant of Figure 7 with a stand alone disk, but with a converging illumination beam.

It is to be noted that the second embodiment can also be used to form a cylindrical grating on an inner circularly cylindrical surface of a transparent tube. As apparent from all given variants, a cylindrical grating fabricated according to the present invention can be formed on a convex or concave wall of an element by using a diverging or a converging light wave impinging on the annular phase mask and/or on said convex or concave wall. In variants where the light wave passes through the element or a support of the phase mask, this element or support is transparent for the used light wave. The annular phase mask can be transmissive or reflective. Thus, several other variants are possible, what the person skilled in the art will easily define from the teaching of the present invention.

The photoresist coated wall onto which the interferogram is projected could also be a cone or any transparent body 34 of smooth surface of circular symmetry with resist layer 38 spread at its surface whose radius R_{co}(z) has a linear or non-linear dependence on the axial coordinate z. The resulting period Λ_{co}(z) of the grating projected onto the cone wall is Λ_{co}(z) = Λ_{φ}+R_{co}(z)/2; the angular period remains the same and is independent of z, but the period Λ_{co} at the surface varies with z and is proportional to R_{co}(z).

## Claims

1. Fabrication method of a cylindrical grating at a circularly cylindrical surface (7; 17) of an element (3; 13), **characterized by** the following steps:
- providing a plan radial grating (1; 40) defining an annular phase mask with radial lines;
- coating said circularly cylindrical surface with a photoresist layer (8);
- arranging said circularly cylindrical surface relative to said annular phase mask so that the central axis (A) of this circularly cylindrical surface comprises the center (0) of the annular phase mask, so that said central axis is substantially perpendicular to the plane defined by said annular phase mask, and so that a medium or media between this annular phase mask and the photoresist layer on the circularly cylindrical surface is transparent at least for a given wavelength;
- exposing said annular phase mask with a light wave substantially at said given wavelength and substantially under purely conical incidence, said plan radial grating having a period selected so as to have the +1^{st} and -1^{st} diffraction orders propagating in said medium or media between the annular phase mask and the photoresist layer, the incidence angle of said light wave on said annular phase mask being selected so that said +1^{st} and -1^{st} diffraction orders impinge on said photoresist layer in a zone where the cylindrical grating shall be located;
- developing the photoresist layer resulting in a circularly cylindrical photoresist corrugation grating (9) having lines parallel to said central axis.

2. Fabrication method of a cylindrical grating according to claim 1, **characterized in that** said annular phase mask (1) is a transmission phase mask directly arranged on a top face (2) of said element (3) which is transparent for said given wavelength, and **in that** said light wave is propagating in a diverging manner relative to said central axis (A) when impinging on said annular phase mask.

3. Fabrication method of a cylindrical grating according to claim 1, **characterized in that** said annular phase mask (1; 12) is a transmission phase mask arranged on, under or into a stand alone disk or wafer (30) arranged over or on a top face (2) of said element (3), this disk or wafer being transparent for said given wavelength.

4. Fabrication method of a cylindrical grating according to claim 3, **characterized in that** said annular phase mask (1) has an external radius smaller than the radius (R) of said circularly cylindrical surface, said element being transparent for said given wavelength, and **in that** said light wave is propagating in a diverging manner relative to said central axis (A) when impinging on the annular phase mask.

5. Fabrication method of a cylindrical grating according to claim 2 or 4, **characterized in that** said light wave is provided by means of a high aperture microscope objective (19) centered on said central axis.

6. Fabrication method of a cylindrical grating according to claim 3, **characterized in that** said annular phase mask (40) has an internal radius greater than the radius (R) of said circularly cylindrical surface, and **in that** said light wave is propagating in a converging manner relative to said central axis (A) when impinging on the annular phase mask.

7. Fabrication method of a cylindrical grating according to claim 1, **characterized in that** said annular phase mask (40) is arranged on a support (42) having a hole in which said element (3) is arranged.

8. Fabrication method of a cylindrical grating according to claim 7, **characterized in that** said light wave is propagating in a converging manner relative to said central axis (A) when impinging on the annular phase mask (40).

9. Fabrication method of a cylindrical grating according to claim 8, **characterized in that** an annular conical mirror (41) surrounding said annular phase mask (40) reflects said light wave in direction of this annular phase mask.

10. Fabrication method of a cylindrical grating according to any of claims 7 to 9, **characterized in that** said annular phase mask is a reflective phase mask.

11. Fabrication method of a cylindrical grating according to any of claims 1 to 4 and 6 to 10, **characterized in that** said light wave is provided by means of a reflective cone (10) centered on said central axis and reflecting an incident light beam into a diverging wave.

12. Fabrication method of a cylindrical grating according to any of claims 1 to 4 and 6 to 10, **characterized in that** said light wave is provided by means of an optical fiber (13) which rotates relative to said annular phase mask (1) with said central axis (A) as rotation axis, the fiber end (14) being substantially on the central axis.

13. Fabrication method of a cylindrical grating according to any of the preceding claims, **characterized in that** said circularly cylindrical surface (7) is convex and defines an external wall of said element (3).

14. Fabrication method of a cylindrical grating according to any of claims 1 to 12, **characterized in that** said circularly cylindrical surface (17) is concave and defines an internal wall of said element (13).

15. Fabrication method of a cylindrical grating according to any of the preceding claims, **characterized in that** a layer (6) is deposited on the area outside said annular phase mask, this layer being absorptive or reflective when this annular phase mask is used in transmission, respectively absorptive or transmissive when this annular phase mask is used in reflection.

16. Fabrication method of a cylindrical grating according to any of the preceding claims, **characterized in that** it comprises a final step consisting in forming said cylindrical grating by physically transferring or embossing or injection moulding or extruding said circularly cylindrical photoresist corrugation grating.
